# EUROPEAN PATENT APPLICATION

(11) **EP 4 615 194 A1**
(43) Date of publication of application: **10.09.2025**
(21) Application number: 25160429.4
(22) Date of filing: 26.02.2025
(51) Int. Cl.: H10F 39/00, H04N 25/47

(54) **HYBRID PIXEL AND HYBRID SENSOR**

(30) Priority: 07.03.2024 KR 20240032844; 26.06.2024 KR 20240083742
(71) Applicant: Samsung Electronics Co., Ltd., Suwon-si, Gyeonggi-do 16677 (KR)
(72) Inventor: SHIM, Eunsub, 16677 Suwon-si (KR); KUDO, Yoshiharu, 230-0027 Yokohama-shi (KR); KIM, Junseok, 16677 Suwon-si (KR); LEE, Jaeho, 16677 Suwon-si (KR)
(74) Representative: Marks & Clerk LLP

(57) **Abstract**

Provided is a hybrid pixel including a semiconductor substrate, a pixel circuit including at least one transfer transistor, a sensing circuit configured to detect movement of an object, and at least one photodiode having one end connected to the pixel circuit and another end connected to the sensing circuit, the semiconductor substrate having a first conductivity type, the semiconductor substrate including a photoelectric conversion area corresponding to the at least one photodiode, the photoelectric conversion area including a first area of a second conductivity type and a second area, the second area is physically separated from a second area of an adjacent hybrid pixel by a deep trench isolation area, and the semiconductor substrate including the deep trench isolation area.

## Description

### BACKGROUND

The inventive concepts relate to hybrid pixels and hybrid sensors. More particularly, the inventive concepts relate to hybrid pixels and hybrid sensors, which are capable of performing both a function of an image sensor and a function of a dynamic vision sensor.

An image sensor is a semiconductor device that converts an optical signal incident from the outside into an electrical signal, and generates image information corresponding to the incident optical signal. With the recent development of computer industries and communication industries, demands for image sensors have increased in various fields such as digital cameras, camcorders, a mobile phone, surveillance cameras, and medical micro-cameras. An image sensor may be capable of generating an image of excellent image quality however, the image sensor may also consume a lot of power.

A vision sensor, for example, a dynamic vision sensor, generates information about an event, e.g., an event signal, when the event (e.g., a change in intensity of light) occurs, and transmits the event signal to a processor. A vision sensor has low power consumption because a result is output only in a pixel where a signal change has occurred, but is able to output only information about an event.

Recently, there have been attempts to achieve a fast frame rate with high image quality by combining an image of an image sensor and an image of a dynamic vision sensor. When a portion of a pixel area is used as a dynamic vision sensor, signal-to-noise ratio (SNR) deterioration may occur due to a decrease in the amount of light and it may be difficult to design pixels.

### SUMMARY

The inventive concepts provide hybrid sensors capable of using both holes and electrons of a photodiode.

According to some aspects of the inventive concepts, there is provided a hybrid pixel.

The hybrid pixel includes a semiconductor substrate, a pixel circuit including at least one transfer transistor, a sensing circuit configured to detect movement of an object, and at least one photodiode having one end connected to the pixel circuit and another end connected to the sensing circuit, the semiconductor substrate having a first conductivity type, the semiconductor substrate including a photoelectric conversion area corresponding to the at least one photodiode, the photoelectric conversion area including a first area of a second conductivity type and a second area surrounding the first area, the second area is physically separated from a second area of an adjacent hybrid pixel by a deep trench isolation area, and the semiconductor substrate including the deep trench isolation area.

According to some aspects of the inventive concepts, there is provided a hybrid pixel.

The hybrid pixel includes a semiconductor substrate, a pixel circuit including at least one transfer transistor, a sensing circuit configured to detect movement of an object, and at least one photodiode having one end connected to the pixel circuit and another end connected to the sensing circuit, the semiconductor substrate having a first conductivity type, the semiconductor substrate including a photoelectric conversion area corresponding to the at least one photodiode, the photoelectric conversion area including a first area of a second conductivity type and a second area, the second area physically separated from a second area of an adjacent hybrid pixel by a deep trench isolation area, and a first layer including the pixel circuit and the at least one photodiode is different from a second layer including the sensing circuit.

According to some aspects of the inventive concepts, there is provided a hybrid sensor.

The hybrid sensor includes a pixel array including a plurality of hybrid pixels, the plurality of hybrid pixels including a photodiode, a pixel circuit connected to one end of the photodiode, a sensing circuit connected to another end of the photodiode, and a noise removal circuit connected between the sensing circuit and the other end of the photodiode, and each of the plurality of hybrid pixels is physically separated from an adjacent hybrid pixel by a deep trench isolation area.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a block diagram of an image processing apparatus according to some example embodiments;
FIG. 2 is a block diagram of a hybrid sensor according to some example embodiments;
FIGS. 3A, 3B, and 3C are diagrams illustrating implementation examples of a pixel array corresponding to a color filter array, according to some example embodiments;
FIG. 4A is a diagram for describing a circuit diagram of a hybrid pixel, according to some example embodiments;
FIG. 4B illustrates some example embodiments of a circuit diagram of the hybrid pixel of FIG. 4A;
FIG. 5A is a cross-sectional view of a layout region corresponding to an A region of FIG. 4B;
FIG. 5B is a diagram for describing a flow of charges in the cross-sectional view of FIG. 5A;
FIG. 6A is a diagram for describing a circuit diagram of a hybrid pixel, according to some example embodiments;
FIG. 6B is a layout plan view illustrating some components of the hybrid pixel of FIG. 6A;
FIG. 6C is a cross-sectional view taken along a line A-A' of FIG. 6B;
FIG. 7 is a circuit diagram of a hybrid pixel according to some example embodiments;
FIG. 8 illustrates a stack structure of a hybrid sensor, according to some example embodiments;
FIG. 9 illustrates a stack structure of a hybrid sensor, according to some example embodiments;
FIG. 10A illustrates a stack structure of components of a hybrid pixel included in a hybrid sensor, according to some example embodiments;
FIG. 10B illustrates a stack structure of components of a hybrid pixel included in a hybrid sensor, according to some example embodiments;
FIG. 11 is a block diagram of a structure of a hybrid pixel, according to some example embodiments;
FIG. 12 is a circuit diagram of a hybrid pixel, according to some example embodiments;
FIG. 13 is a timing diagram for describing turn-on timing of transistors included in a noise removal circuit of FIG. 12;
FIG. 14 is a timing diagram for describing turn-on timing of transistors included in a noise removal circuit according to some example embodiments; and
FIG. 15 is a timing diagram for describing turn-on timing of transistors included in a noise removal circuit according to some example embodiments.

### DETAILED DESCRIPTION

Hereinafter, various embodiments will be described with reference to accompanying drawings.

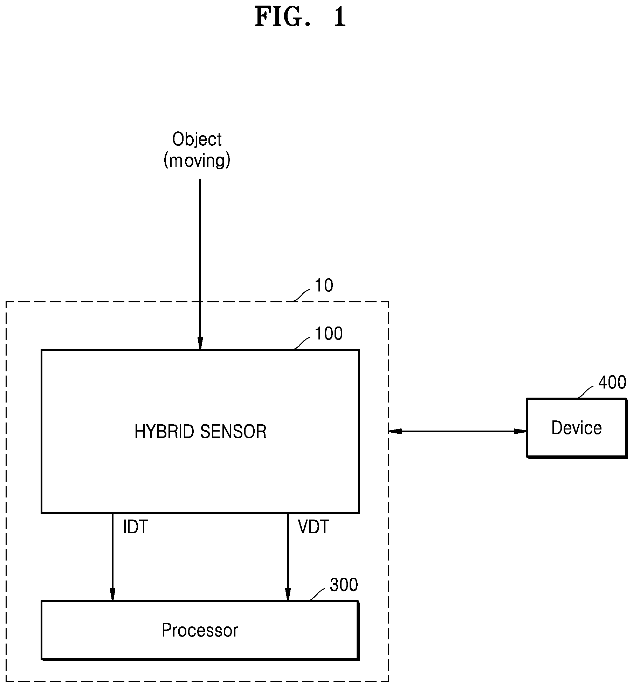

FIG. 1 is a block diagram of an image processing apparatus 10 according to some example embodiments.

Referring to FIG. 1, the image processing apparatus 10 may include a hybrid sensor 100 and a processor 300. The image processing apparatus 10 according to some example embodiments may be mounted on an electronic device having an image or optical sensing function. For example, the image processing apparatus 10 may be mounted on an electronic device such as a camera, a smartphone, a wearable device, an Internet of things (IoT) device, a tablet personal computer (PC), a personal digital assistant (PDA), a portable multimedia player (PMP), a navigation device, a drone, or an advanced driver assistance system (ADAS). Also, the image processing apparatus 10 may be included, as a component, in a vehicle, furniture, manufacturing equipment, a door, or any type of measuring device.

The hybrid sensor 100 may be a sensor capable of performing both a vision sensor function and an image sensor function. The vision sensor function may be a function of outputting an event signal by detecting a change in intensity of incident light. The vision sensor function provided by the hybrid sensor 100 may be a dynamic vision sensor function of outputting event signals for pixels where a change in intensity of light has been detected, e.g., for pixels where an event has occurred. The change in intensity of light may be caused by movement of an object photographed by the hybrid sensor 100 or caused by movement of the hybrid sensor 100 or image processing apparatus 10 itself. The hybrid sensor 100 may periodically or aperiodically transmit, to the processor 300, pieces of vision sensor data VDT including the event signals.

The image sensor function is a function of converting an optical signal of an object, which is incident through an optical lens, into an electrical signal, generating image data IDT based on the electrical signals, and outputting the image data IDT. The hybrid sensor 100 may include, for example, a readout circuit and a pixel array including a plurality of pixels arranged two dimensionally, and the pixel array may convert received optical signals into electrical signals. The pixel array may be implemented with a photoelectric conversion element, for example, a charge coupled device (CCD) or a complementary metal oxide semiconductor (CMOS), or may be implemented with any type of photoelectric conversion element. The readout circuit may generate raw data based on the electrical signal provided from the pixel array and output, as the image data IDT, the raw data or raw data on which preprocessing such as bad pixel removal has been performed. The hybrid sensor 100 may be implemented with a semiconductor chip or package including the pixel array and the readout circuit.

According to the inventive concepts, the hybrid sensor 100 may perform both the image sensor function and the vision sensor function respectively based on pieces of information (e.g., electrons and holes) obtained from at least one photodiode included in a hybrid pixel. The hybrid pixel included in the pixel array included in the hybrid sensor 100 may include the at least one photodiode, a pixel circuit connected to one end of the photodiode, and a sensing circuit connected to another end of the photodiode.

The processor 300 may perform image processing on the image data IDT provided from the hybrid sensor 100. For example, the processor 300 may perform image processing of changing a data format of the image data IDT (e.g., changing image data of a Bayer pattern to a YUV or RGB format), image processing for image quality improvement, such as noise removal, brightness adjustment, or sharpness adjustment, and/or the like. The processor 300 may process the vision sensor data VDT received from the hybrid sensor 100 and detect movement of the object (or movement of the object in an image recognized by the image processing apparatus 10), based on the event signal in the vision sensor data VDT.

Also, the processor 300 may match an image frame included in the image data IDT provided from the hybrid sensor 100 with the vision sensor data VDT received from the hybrid sensor 100, based on a timestamp and pieces of synchronization signal information. The processor 300 may include an application specific integrated circuit (ASIC), a field-programmable gate array (FPGA), a dedicated microprocessor, a microprocessor, or a general purpose processor. According to some example embodiments, the processor 300 may be an application processor or an image signal processor.

The hybrid sensor 100 and the processor 300 may each be implemented as an integrated circuit (IC). For example, the hybrid sensor 100 and the processor 300 may be implemented as separate semiconductor chips. Alternatively, the hybrid sensor 100 and the processor 300 may be implemented as a single chip. For example, the hybrid sensor 100 and the processor 300 may be implemented as a system-on-chip (SoC).

The image processing apparatus 10 may control an external device 400 and collect data. The device 400 may include an acceleration sensor, an inertial measurement unit (IMU), a gyro sensor, an infrared ray (IR) light-emitting diode (LED), and a flash light.

The acceleration sensor is a sensor configured to measure an acceleration of a moving object or strength of an impact, and may measure dynamic force, such as an acceleration, vibration, or impact, of an object by processing an output signal. The gyro sensor is a sensor used for location measurement and direction setting by using dynamic motion of a rotating object. The IR LED is for capturing an image when there is no light, and is a device used in a closed-circuit television (CCTV) and/or the like.

The IMU uses a combination of an accelerometer, a gyroscope, and sometimes a magnetometer, and is recently operated as an orientation sensor in many consumer products, such as a mobile phone and a camera. The IMU operates by detecting linear acceleration by using one or more accelerometers and detecting a rotating speed by using one or more gyroscopes, and may include a magnetometer in some cases. In a general configuration, the IMU may include one accelerometer, one gyroscope, and one magnetometer per axis for three axes of pitch, roll, and yaw.

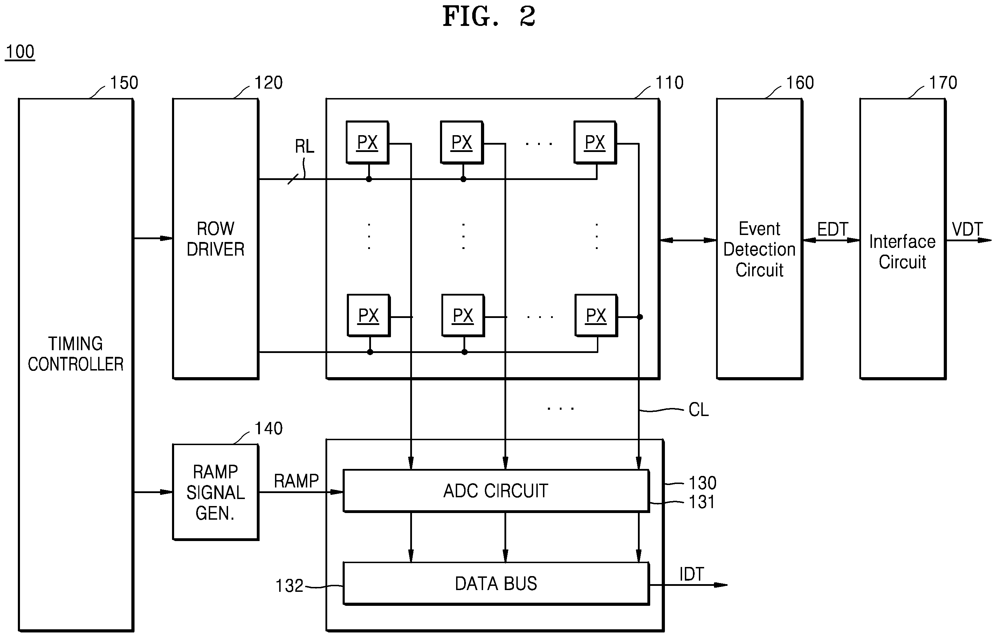

FIG. 2 is a block diagram of the hybrid sensor 100 according to some example embodiments.

The hybrid sensor 100 may include a pixel array 110, a row driver 120, a readout circuit 130, a ramp signal generator 140, a timing controller 150, an event detection circuit 160, and an interface circuit 170, and the readout circuit 130 may include an analog-to-digital conversion (ADC) circuit 131 and a data bus 132.

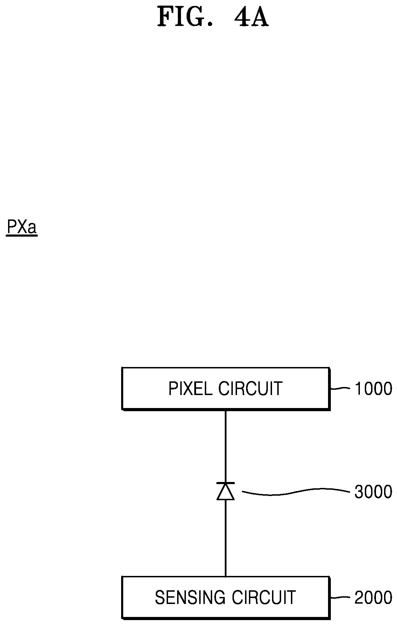

The pixel array 110 includes a plurality of row lines RL, a plurality of column lines CL, and a plurality of pixels PX accessed to (e.g. connected to) the plurality of row lines RL and the plurality of column lines CL, and arranged in a matrix. The plurality of pixels PX may be hybrid pixels. According to some example embodiments, each of the plurality of pixels PX may include a pixel circuit configured to output an image signal and a sensing circuit configured to sense whether an event has occurred. According to some example embodiments, the sensing circuit may detect movement of an object by detecting the movement as an event. The pixel circuit and the sensing circuit included in each of the plurality of pixels PX may share a photodiode included in each of the plurality of pixels PX. According to some example embodiments, the pixel circuit may operate based on electrons of the photodiode and the sensing circuit may operate based on holes of the photodiode. A structure corresponding to the plurality of pixels PX will be described below with reference to FIG. 4A.

Each pixel PX may include at least one photoelectric conversion element. The pixel PX may detect light by using the photoelectric conversion element, and output an image signal that is an electrical signal according to the detected light. For example, the photoelectric conversion element may be a light detection element including an organic material or an inorganic material, such as an inorganic photodiode, an organic photodiode, a perovskite photodiode, a phototransistor, a photogate, and/or a pinned photodiode. According to some example embodiments, each pixel PX may include a plurality of photoelectric conversion elements.

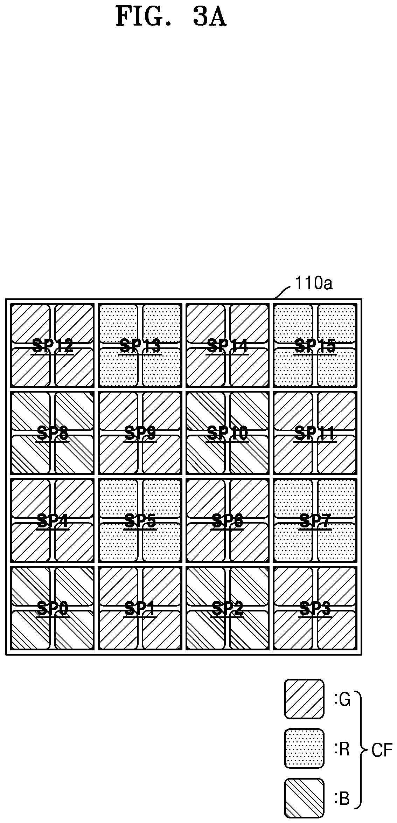

A micro-lens (not shown) for focusing light may be arranged above each pixel PX or above each of pixel groups including adjacent pixels PX. Each of the plurality of pixels PX may detect light of a specific spectrum domain from light received through the micro-lens arranged thereabove. For example, the pixel array 110 may include a red (R) pixel converting light of a red spectrum domain into an electrical signal, a green (G) pixel converting light of a green spectrum domain into an electrical signal, a blue (B) pixel converting light of a blue spectrum domain into an electrical signal, and a white (W) pixel for noise adjustment. A color filter array CF for transmitting light of a specific spectrum domain may be arranged above each of the plurality of pixels PX. This will be described below with reference to FIGS. 3A to 3C. However, some example embodiments is not limited thereto and the pixel array 110 may include pixels converting light of a spectrum domain other than red, green, and blue, into an electrical signal. According to some example embodiments, the pixel PX included in the pixel array 110 may be an RGBW pixel.

Charges generated by the photoelectric conversion element, such as the photodiode, in each pixel PX may be accumulated in a floating diffusion node, and the charges accumulated in the floating diffusion node may be converted into a voltage. A ratio at which the charges accumulated in the floating diffusion node are converted into a voltage may be referred to as a conversion gain. The conversion gain may vary according to capacitance of the floating diffusion node.

The row driver 120 may drive the pixel array 110 in units of row lines RL. The row driver 120 may select at least one row line RL from among the row lines RL configuring the pixel array 110. For example, the row driver 120 may generate a selection signal of selecting one of the plurality of row lines RL. The pixel array 110 may output a pixel signal from the row line RL selected according to the selection signal. The pixel signal may include a reset signal and an image signal.

The row driver 120 may generate control signals for controlling the pixel array 110. For example, the row driver 120 may generate control signals for controlling transistors included in the sensing circuit and pixel circuit included in the pixel PX. The row driver 120 may independently (for example, alone or without direction or interference from another element/feature) provide the control signals for controlling the transistors included in the sensing circuit and pixel circuit included in the pixel PX. The row driver 120 may provide the control signals to the plurality of pixels PX, in response to a timing control signal provided by the timing controller 150.

The timing controller 150 may control timings of the row driver 120, readout circuit 130, and ramp signal generator 140. The timing controller 150 may provide control signals for controlling operating timings of the row driver 120, the readout circuit 130, and the ramp signal generator 140, respectively. The timing controller 150 may adjust timings of a plurality of control line signals generated by the row driver 120 to determine activating and deactivating timings of signals applied to a control line. A detailed timing control method of the timing controller 150 will be described below.

The ramp signal generator 140 may generate a ramp signal RAMP that is increased or decreased in a certain inclination, and provide the ramp signal RAMP to the ADC circuit 131 of the readout circuit 130.

The readout circuit 130 may read out a pixel signal from the pixels PX of the row line RL selected by the row driver 120, from among the plurality of pixels PX. The readout circuit 130 may convert pixel signals received from the pixel array 110 through the plurality of column lines CL into digital data, based on the ramp signal RAMP provided from the ramp signal generator 140, and generate and output pixel values corresponding to the plurality of pixels PX in units of rows.

The ADC circuit 131 may compare each of the pixel signals received through column lines CL with the ramp signal RAMP and generate a pixel value that is a digital signal, based on results of the comparison. For example, the reset signal may be removed from the image signal and a pixel value indicating the amount of light detected in the pixel PX may be generated. The ADC circuit 131 may sample and hold the pixel signal according to a correlated double sampling (CDS) method and double-sample a level of specific noise (e.g., the reset signal) and a level according to the image signal, thereby generating a comparison signal based on a level corresponding to a difference therebetween. The ADC circuit 131 may first read out the image signal and sample the pixel signal provided by reading out the reset signal, according to a delta reset sampling (DRS) method.

The plurality of pixel values generated by the ADC circuit 131 may be output through the data bus 132, as the image data IDT. The image data IDT may be provided to an image signal processor inside or outside the hybrid sensor 100.

The data bus 132 may temporarily store the pixel value output from the ADC circuit 131 and then output the same. The data bus 132 may include a plurality of column memories and a column decoder. The plurality of pixel values stored in the plurality of column memories may be output as the image data IDT, under control by the column decoder.

According to some example embodiments, each of the plurality of pixels PX may detect events in which intensity of received light is increased or decreased. For example, each of the plurality of pixels PX may be connected to the event detection circuit 160 through a column line extending in a column direction and a row line extending in a row direction. A signal indicating that an event has occurred and polarity information of the event (e.g. whether the event is an on-event in which intensity of light is increased or an off-event in which intensity of light is decreased) may be output from the pixel PX where the event has occurred to the event detection circuit 160. In the inventive concepts, a signal output from the pixel PX to the event detection circuit 160 is referred to as an event detection signal.

The event detection circuit 160 may readout events from the pixel array 110 and process the events. The event detection circuit 160 may generate event data EDT including polarity information of an occurred event, an address of a pixel where the event has occurred, and a timestamp. The event detection circuit 160 may process events occurred in the pixel array 110 in units of pixels, in units of pixel groups including a plurality of pixels, in units of columns, or in units of frames.

The interface circuit 170 may receive the event data EDT and the timestamp, and transmit the vision sensor data VDT to the processor 300 according to a set protocol. The interface circuit 170 may pack the event data EDT and the timestamp in units of individual signals, in units of packets, or in units of frames, according to the set protocol, to generate the vision sensor data VDT, and transmit the vision sensor data VDT to the processor 300 (see FIG. 1). For example, the interface circuit 170 may include at least one of an address event representation (AER) interface, a mobile industry processor interface (MIPI), and/or a parallel interface.

According to the inventive concepts, the image signal and the event detection signal may be simultaneously (e.g., at the same or about the same time) output from the pixel PX included in the pixel array 110. In other words, according to the inventive concepts, the pixel PX included in the pixel array 110 may be a hybrid pixel capable of outputting both the image signal and the event detection signal. Accordingly, desired pieces of image data may be combined and data usability may be increased.

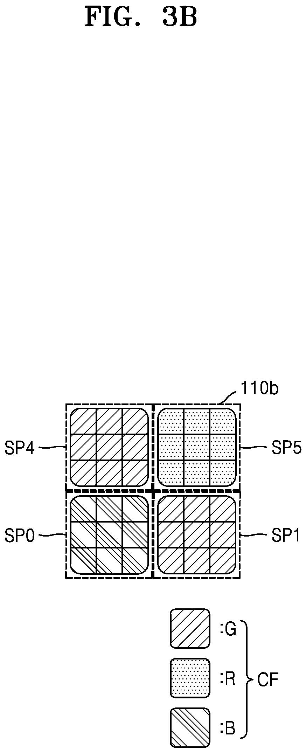

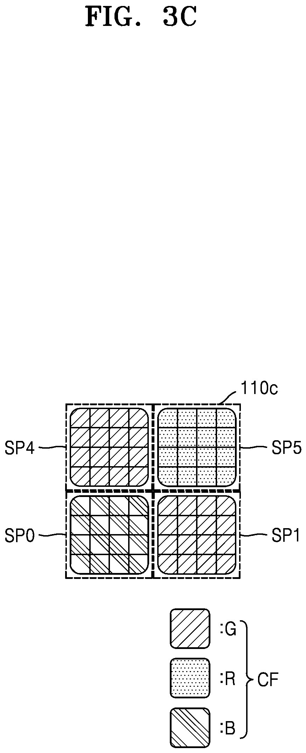

FIGS. 3A, 3B, and 3C are diagrams illustrating implementation examples of a pixel array corresponding to a color filter array, according to some example embodiments.

Referring to FIG. 3A, a pixel array 110a includes a plurality of pixels arranged in a plurality of rows and a plurality of columns, and for example, a shared pixel defined in a unit including pixels arranged in two rows and two columns may include four sub-pixels. The pixel array 110a may include first to sixteenth shared pixels SP0 to SP15. The pixel array 110a may further include the color filter array CF for the first to sixteenth shared pixels SP0 to SP15 to sense various colors. For example, the color filter array CF includes filters sensing red(R), green (G), and blue (B), and each of the first to sixteenth shared pixels SP0 to SP15 may include sub-pixels where a same color filter is arranged. For example, the first shared pixel SP0, the third shared pixel SP2, the ninth shared pixel SP8, and the eleventh shared pixel SP10 may include sub-pixels including a blue color filter, the second shared pixel SP1, the fourth shared pixel SP3, the fifth shared pixel SP4, the seventh shared pixel SP6, the tenth shared pixel SP9, the twelfth shared pixel SP11, the thirteenth shared pixel SP12, and the fifteenth shared pixel SP14 may include sub-pixels including a green color filter, and the sixth shared pixel SP5, the eighth shared pixel SP7, the fourteenth shared pixel SP13, and the sixteenth shared pixel SP15 may include sub-pixels including a red color filter. Also, a group including the first shared pixel SP0, the second shared pixel SP1, the fifth shared pixel SP4, and the sixth shared pixel SP5, a group including the third shared pixel SP2, the fourth shared pixel SP3, the seventh shared pixel SP6, and the eighth shared pixel SP7, a group including the ninth shared pixel SP8, the tenth shared pixel SP9, the thirteenth shared pixel SP12, and the fourteenth shared pixel SP13, and a group including the eleventh shared pixel SP10, the twelfth shared pixel SP11, the fifteenth shared pixel SP14, and the sixteenth shared pixel SP15 may each be arranged in the pixel array 110a to correspond to a Bayer pattern. According to some example embodiments, the group including the first shared pixel SP0, the second shared pixel SP1, the fifth shared pixel SP4, and the sixth shared pixel SP5, the group including the third shared pixel SP2, the fourth shared pixel SP3, the seventh shared pixel SP6, and the eighth shared pixel SP7, the group including the ninth shared pixel SP8, the tenth shared pixel SP9, the thirteenth shared pixel SP12, and the fourteenth shared pixel SP13, and the group including the eleventh shared pixel SP10, the twelfth shared pixel SP11, the fifteenth shared pixel SP14, and the sixteenth shared pixel SP15 may each correspond to a block of the color filter array CF.

However, this is only an example and the pixel array 110a according to some example embodiments may include various types of color filters. For example, the color filter array CF may include filters sensing not only red, green, and blue, but also yellow, cyan, magenta, and white. Also, the pixel array 110a may include more shared pixels, and arrangements of the first to sixteenth shared pixels SP0 to SP15 may vary.

Referring to a pixel array 110b of FIG. 3B, each of the first, second, fifth, and sixth shared pixels SP0, SP1, SP4, and SP5 may include nine sub-pixels. The first shared pixel SP0 may include nine sub-pixels including a blue (B) color filter, and the second shared pixel SP1 and the fifth shared pixel SP4 may each include nine sub-pixels including a green (G) color filter. The sixth shared pixel SP5 may include nine sub-pixels including red (R) color filter. According to some embodiments, the first, second, fifth, and sixth shared pixels SP0, SP1, SP4, and SP5 may be referred to as nona cells.

Referring to a pixel array 110c of FIG. 3C, each of the first, second, fifth, and sixth shared pixels SP0, SP1, SP4, and SP5 may include sixteen sub-pixels. The first shared pixel SP0 may include sixteen sub-pixels including a blue (B) color filter, and the second shared pixel SP1 and the fifth shared pixel SP4 may each include sixteen sub-pixels including a green (G) color filter. The sixth shared pixel SP5 may include sixteen sub-pixels including a red (R) color filter. According to some embodiments, the first, second, fifth, and sixth shared pixels SP0, SP1, SP4, and SP5 may be referred to as hexadeca cells.

A shared pixel may include sub-pixels that are adjacent to each other while including a same color filter. A shared pixel of FIGS. 3A to 3C is illustrated as an example including sub-pixels having an N*N arrangement, but an arrangement of sub-pixels included in a shared pixel is not limited to N*N. N may be a natural number equal to or greater than 2.

FIG. 4A is a diagram for describing a circuit diagram of a hybrid pixel PXa, according to some example embodiments.

Referring to FIG. 4A, the hybrid pixel PXa may include a photodiode 3000, a pixel circuit 1000 connected to one end of the photodiode 3000, and a sensing circuit 2000 connected to another end of the photodiode 3000. According to some example embodiments, a cathode of the photodiode 3000 may be connected to the pixel circuit 1000 and an anode of the photodiode 3000 may be connected to the sensing circuit 2000.

The pixel circuit 1000 may generate a pixel signal of a voltage according to an amount of charged generated in the photodiode 3000. The sensing circuit 2000 may generate an event detection signal by detecting whether an amount of change in charges generated in the photodiode 3000 has exceeded a certain threshold value. The pixel circuit 1000 included in the hybrid pixel PXa according to the inventive concepts may generate the pixel signal based on electrons generated in the photodiode 3000, and the sensing circuit 2000 may generate the event detection signal based on holes generated in the photodiode 3000. Accordingly, the pixel circuit 1000 may use a current based on electrons and the sensing circuit 2000 may use a current based on holes. In this case, even when electrons are accumulated in the photodiode 3000, the current based on holes may continuously flow, and thus, the pixel circuit 1000 may maintain a 4T operation, operate as a circuit separate from the sensing circuit 2000, and may have various share structures. In some example embodiments, the pixel signal generated from electrons may have less noise compared to when a pixel signal is generated from holes, and as such, a signal quality of a pixel signal may be improved. In some example embodiments, the sensing circuit 2000 uses a hole current, and thus, the hybrid pixel PXa may be implemented with improved performance and reliability with regards to light loss or pixel operation.

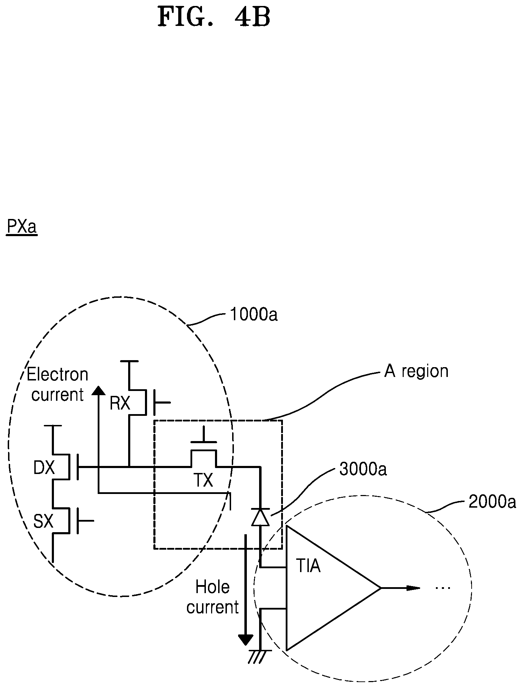

FIG. 4B illustrates some example embodiments of a circuit diagram of the hybrid pixel PXa of FIG. 4A.

Referring to FIG. 4B, the hybrid pixel PXa may include a photodiode 3000a, a pixel circuit 1000a, and a sensing circuit 2000a. The pixel circuit 1000a may include a transfer transistor TX, a reset transistor RX, a driving transistor DX, and a selection transistor SX. Description about an operating method of the pixel circuit 1000a is omitted. Referring to FIG. 4B, one end of the transfer transistor TX included in the pixel circuit 1000a may be connected to a cathode of the photodiode 3000a. The sensing circuit 2000a may include a transimpedance amplifier TIA. According to some example embodiments, the transimpedance amplifier TIA may amplify a value of current corresponding to holes output from an anode of the photodiode 3000a and output the same (or about the same) as a voltage. Although omitted for convenience of description in the inventive concepts, the sensing circuit 2000a may further include a comparator configured to compare an amplified hole current value with a reference value. According to some example embodiments, the sensing circuit 2000a may be a circuit corresponding to a dynamic vision sensor configured to output an event detection signal. Description about an operating method of the sensing circuit 2000a will be omitted.

Circuit structures of the pixel circuit 1000a and sensing circuit 2000a of FIG. 4B are only examples, and the pixel circuit 1000a and the sensing circuit 2000a may be variously changed respectively within ranges capable of performing a circuit structure of reading out a pixel signal and a circuit structure of comparing an amount of change in charges with a threshold value and outputting an event detection signal. For example, according to some example embodiments, there may be an increase in speed, accuracy, and/or power efficiency of the image processing device based on the above methods. Therefore, the improved devices and methods overcome the deficiencies of the conventional devices and methods while reducing resource consumption, and improving data accuracy, and resource allocation (e.g., latency).

According to some example embodiments, the pixel circuit 1000a and the sensing circuit 2000a included in the hybrid pixel PXa may share the photodiode 3000a. Accordingly, both a function of an image sensor and a function of a dynamic vision sensor may be performed based at least one photodiode 3000a included in one hybrid pixel PXa.

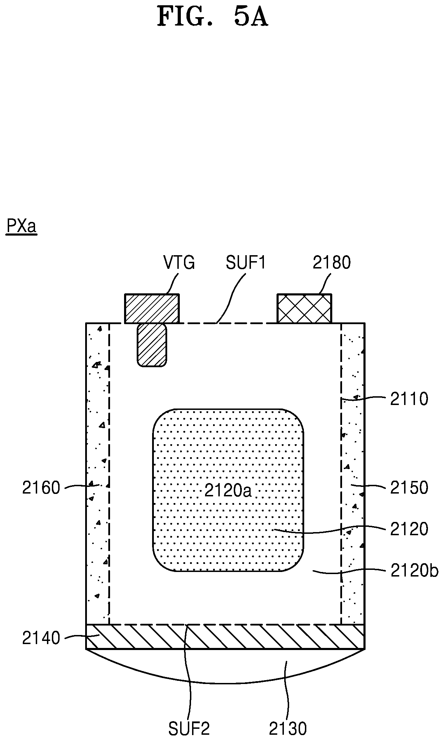

FIG. 5A is a cross-sectional view of a layout region corresponding to an A region of FIG. 4B. Referring to FIG. 5A, the hybrid pixel PXa may include a semiconductor substrate 2110, a photoelectric conversion area 2120, a vertical transfer gate VTG, a micro-lens 2130, a color filter 2140, deep trench isolation (DTI) areas 2150 and 2160, and a contact area 2180.

The semiconductor substrate 2110 may include a first surface SUF1 and a second surface SUF2 facing the first surface SUF1. Impurities (e.g., boron (B)) of a first conductivity type (e.g., a p type) may be injected into the semiconductor substrate 2110, and impurities (e.g., phosphorus (P) or arsenic (As)) of a second conductivity type (e.g., an n type) opposite to the first conductivity type may be injected to a floating diffusion area. Although not illustrated, a p-type epitaxial layer may be grown or a separate well area may be formed above the semiconductor substrate 2110 to form the photoelectric conversion area 2120 and the vertical transfer gate VTG on the p-type epitaxial layer and/or the well area.

The photoelectric conversion area 2120 may be formed inside the semiconductor substrate 2110 and incident light may reach the photoelectric conversion area 2120 through the second surface SUF2 of the semiconductor substrate 2110. The photoelectric conversion area 2120 may be an area corresponding to the photodiode 3000. The photoelectric conversion area 2120 may generate charges (e.g., photo charges or holes) in a PN junction region according to photoelectric conversion, based on incident light. The number of electrons generated may increase as luminance increases. The number of holes generated may be the same as the number of electrons. According to some example embodiments, the photoelectric conversion area 2120 may be an area formed as the second conductivity type (e.g., the n type) is injected. An area and shape of the photoelectric conversion area 2120 are not limited to those shown in FIG. 5A.

Referring to FIG. 5A, the semiconductor substrate 2110 may include a first area 2120a and a second area 2120b. According to some example embodiments, the first area 2120a may be an area corresponding to the photoelectric conversion area 2120. According to some example embodiments, the second area 2120b may be an area surrounding the first area 2120a in the semiconductor substrate 2110. According to some example embodiments, the second area 2120b may be a remaining area obtained by excluding an area where the photoelectric conversion area 2120 from the semiconductor substrate 2110. According to some example embodiments, the second area 2120b may be an area in the semiconductor substrate 2110, where hole transfer is possible between areas where holes are accumulated.

According to some example embodiments, the contact area 2180 may be formed on the first surface SUF1 of the semiconductor substrate 2110. According to some example embodiments, the contact area 2180 may be formed in the semiconductor substrate 2110 and provide a transfer path of holes formed in the second area 2120b. According to some example embodiments, holes formed in the second area 2120b may be transferred to a sensing circuit 2000a along the contact area 2180.

The vertical transfer gate VTG may be formed on the first surface SUF1 of the semiconductor substrate 2110. A portion of the vertical transfer gate VTG may extend from the first surface SUF1 of the semiconductor substrate 2110 into the semiconductor substrate 2110 towards the photoelectric conversion area 2120. The vertical transfer gate VTG may allow electrons generated in the first area 2120a of the photoelectric conversion area 2120 to be transferred to a floating diffusion area.

According to the inventive concepts, electrons generated in the first area 2120a may be transferred to the pixel circuit 1000a through the vertical transfer gate VTG, and holes generated in the second area 2120b may be transferred to the sensing circuit 2000a through the contact area 2180.

The hybrid pixel PXa may include the DTI areas 2150 and 2160. According to some example embodiments, the DTI areas 2150 and 2160 may extend from the first surface SUF1 of the semiconductor substrate 2110 to a depth spaced apart from the first surface SUF1, or may completely (e.g., fully) penetrate the semiconductor substrate 2110 from the first surface SUF1 to the second surface SUF2 of the semiconductor substrate 2110. The DTI areas 2150 and 2160 may be in contact with the first surface SUF1 and/or the second surface SUF2 of the semiconductor substrate 2110. According to some example embodiments, surfaces where the DTI areas 2150 and 2160 and the semiconductor substrate 2110 are in contact with each other may not be parallel to each other. According to some example embodiments, the DTI areas 2150 and 2160 may form isolation areas by contacting a shallow trench isolation (STI) area formed in the first surface SUF1 or the second surface SUF2. According to some example embodiments, the DTI areas 2150 and 2160 may be isolation areas formed by front DTI (FDTI). The DTI areas 2150 and 2160 may include an insulating layer and/or a conductive layer. For example, the DTI areas 2150 and 2160 may include a silicon oxide layer formed along an inner wall of a trench and a silicon layer filling a remaining portion of the trench. According to some example embodiments, thicknesses of the DTI areas 2150 and 2160 may not be uniform.

According to the inventive concepts, the DTI areas 2150 and 2160 may be formed to isolate the first area 2120a and the second area 2120b included in the hybrid pixel PXa from a first area and a second area included in an adjacent hybrid pixel Pxa. According to the inventive concepts, the first area 2120a and the second area 2120b are formed inside the semiconductor substrate 2110 and the contact area 2180 is formed above the semiconductor substrate 2110, and to secure a complete transfer path of holes, the second area 2120b and the contact area 2180 corresponding thereto need to be completely (e.g., fully) isolated from a contact area arranged in an adjacent pixel. Accordingly, the DTI areas 2150 and 2160 may be formed on both sides of the first area 2120a and the second area 2120b to configure an individual pixel for the sensing circuit 2000a (and, for example, other sides not shown). According to the inventive concepts, the sensing circuit 2000a may be configured by using hole currents classified for each hybrid pixel by the DTI areas 2150 and 2160.

The hybrid pixel PXa may further include the color filter array CF and the micro-lens 2130 on the second surface SUF2 of the semiconductor substrate 2110. In some example embodiments, the order of the color filter array CF and the micro-lens 2130 may be different. According to some example embodiments, a nano-structure may be located on the second surface SUF2 of the semiconductor substrate 2110, instead of the color filter array CF and/or the micro-lens 2130, and may isolate and/or guide light according to wavelengths.

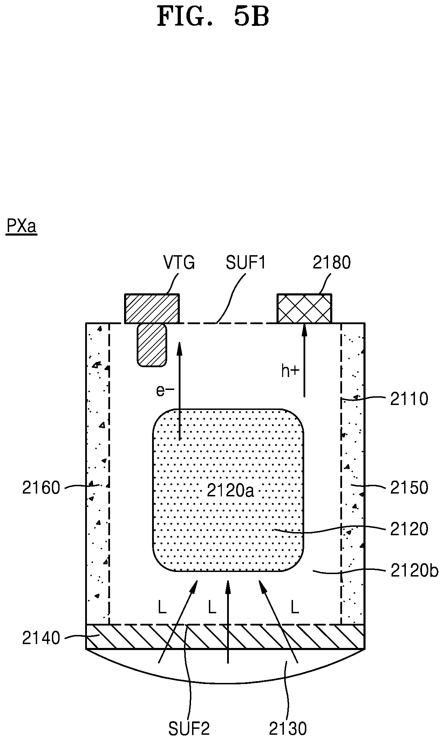

FIG. 5B is a diagram for describing a flow of charges in the cross-sectional view of FIG. 5A. FIG. 5B is a diagram for describing a flow of charges from the first area 2120a and the second area 2120b included in the photoelectric conversion area 2120.

Referring to FIG. 5B, light L transmitted through the micro-lens 2130 may be transmitted to the photoelectric conversion area 2120. When a voltage is applied to the vertical transfer gate VTG, electrons e- formed in the first area 2120a by the light L may flow in a direction towards the vertical transfer gate VTG and may be transmitted to the floating diffusion area of the pixel circuit 1000a. Holes h+ formed in the second area 2120b by the light L may be transferred through the contact area 2180 and a hole current transferred through the contact area 2180 may be transmitted to the sensing circuit 2000a.

According to some example embodiments, electrons may be used to generate a pixel signal and holes may be used to detect an event. Compared to a case where only electrons are used according to a comparative example, a level of a pixel signal may be increased under a same or similar luminance, thereby, a precision of detecting an event may be increased, and image quality at a dark place where luminance is low may be increased.

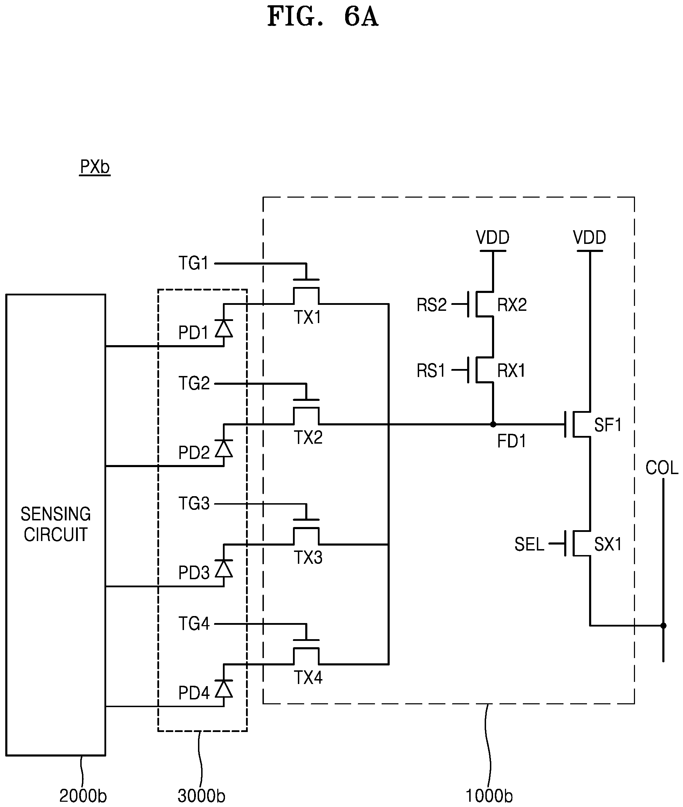

FIG. 6A is a diagram for describing a circuit diagram of a hybrid pixel PXb, according to some example embodiments.

Referring to FIG. 6A, the hybrid pixel PXb may include a pixel circuit 1000b, a sensing circuit 2000b, and a plurality of photodiodes 3000b. The pixel circuit 1000b according to some example embodiments may include first to fourth transfer transistors TX1, TX2, TX3, and TX4, a first floating diffusion node FD1, a source follower transistor SF1, a first selection transistor SX1, and first and second reset transistors RX1 and RX2. A first control signal TG1, a second control signal TG2, a third control signal TG3, and a fourth control signal TG4 for driving the first to fourth transfer transistors TX1, TX2, TX3, and TX4 may be applied to the gates of the first to fourth transfer transistors TX1, TX2, TX3, and TX4, respectively, and a first reset signal RS1 and a second reset signal RS2 may be applied to the gates of the first and second reset transistors RX1, RX2, respectively. An operating method of the pixel circuit 1000b may be similar to that of the pixel circuit 1000, and thus, description thereof is omitted.

Referring to FIG. 6A, the plurality of photodiodes 3000b may include first to fourth photodiodes PD1, PD2, PD3, and PD4. Charges corresponding to light incident on the hybrid pixel PXb through the first to fourth photodiodes PD1, PD2, PD3, and PD4 may be accumulated. An amount of charges accumulated in the first to fourth photodiodes PD1, PD2, PD3, and PD4 may be referred to as light amount data.

The pixel circuit 1000b may be connected to cathodes of the first to fourth photodiodes PD1, PD2, PD3, and PD4. The sensing circuit 2000b may be connected to anodes of the first to fourth photodiodes PD1, PD2, PD3, and PD4. According to some example embodiments, the pixel circuit 1000b and the sensing circuit 2000b may share the first to fourth photodiodes PD1, PD2, PD3, and PD4. In some example embodiments of FIG. 6A, the pixel circuit 1000b and the sensing circuit 2000b share four photodiodes, but the inventive concepts are not limited thereto, and the pixel circuit 1000b and the sensing circuit 2000b may share N photodiodes. N may be a natural number equal to or greater than 2. According to some example embodiments, the number of transfer transistors included in the pixel circuit 1000b and the number of photodiodes 3000b connected to the pixel circuit 1000b may be the same. Referring to FIG. 6A, the number of transfer transistors included in the pixel circuit 1000b may be 4 and the number of photodiodes 3000b connected to the pixel circuit 1000b may be 4.

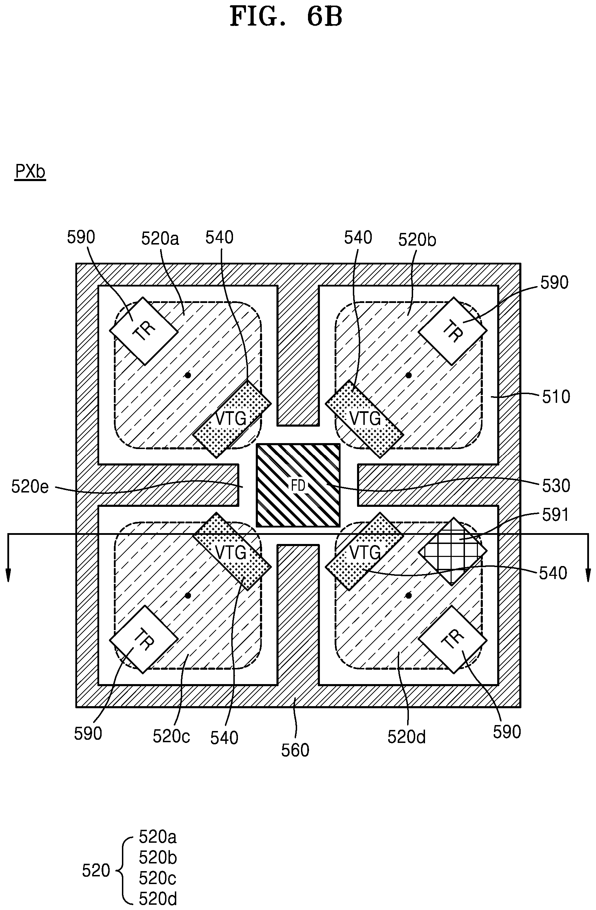

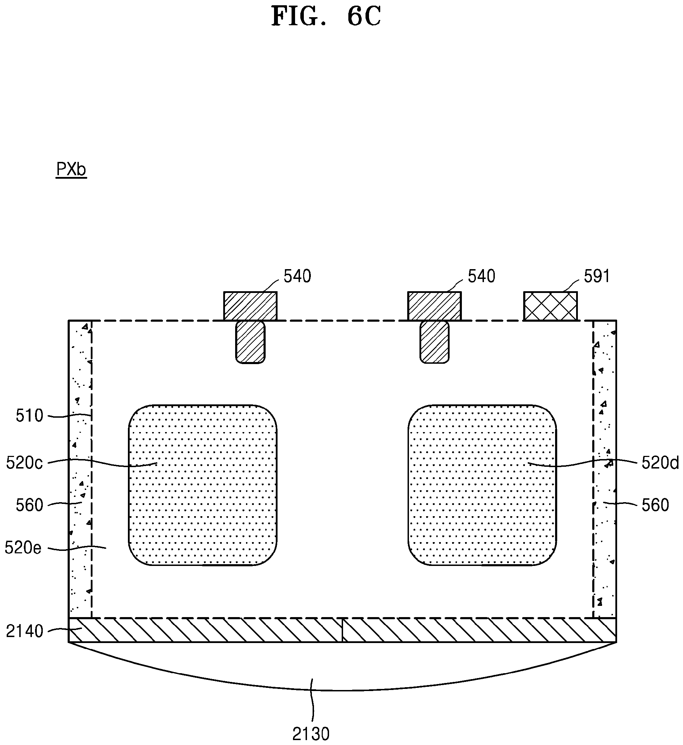

FIG. 6B is a layout plan view illustrating some components of the hybrid pixel PXb of FIG. 6A. FIG. 6C is a cross-sectional view taken along a horizontal line terminating in arrows of FIG. 6B.

Referring to FIG. 6B, four photodiodes, e.g., the first to fourth photodiodes PD1, PD2, PD3, and PD4, included in FIG. 6A may be provided in a 2x2 pixel structure symmetrical based on the center.

The hybrid pixel PXb of FIG. 6B may include one semiconductor substrate 510, a plurality of photoelectric conversion areas 520, one floating diffusion area 530, four vertical transfer gates 540, a DTI area 560, a transistor 590, and a contact area 591. The hybrid pixel PXb of FIG. 6B may have a 4PD structure in which the semiconductor substrate 510 is shared as a center portion of the DTI area 560 is partially deleted.

According to some example embodiments of FIG. 6B, the plurality of photoelectric conversion areas 520 may include first areas 520a, 520b, 520c, and 520d. According to some example embodiments, the first areas 520a, 520b, 520c, and 520d may be areas doped with a second conductivity type (e.g., an n type). Referring to FIG. 6B, the number of first areas 520a, 520b, 520c, and 520d may correspond to the number of photodiodes shared by the pixel circuit 1000b. Referring to FIG. 6B, there are four photodiodes shared by the pixel circuit 1000b, and thus, the number of first areas 520a, 520b, 520c, and 520d may be four. According to some example embodiments of FIG. 6B, the semiconductor substrate 510 may include a second area 520e surrounding the first areas 520a, 520b, 520c, and 520d. According to some example embodiments, the second area 520e surrounding the plurality of first areas 520a, 520b, 520c, and 520d is illustrated. Also, the contact area 591 may be formed above the semiconductor substrate 510. According to some example embodiments, one contact area 591 may correspond to one second area 520e. In other words, the number of second areas 520e and the number of contact areas 591 may be the same. Referring to FIG. 6B, the plurality of first areas 520a, 520b, 520c, and 520d share the second area 520e and share the contact area 591, and thus, the number of contact areas 591 and the number of second areas 520e may be equal to or less than the number of first areas 520a, 520b, 520c, and 520d. A location where the contact area 591 is arranged may vary within a range in contact with the second area 520e, above the semiconductor substrate 510.

Referring to FIG. 6C, the hybrid pixel PXb includes the semiconductor substrate 510, the first areas 520c and 520d, the second area 520e, the contact area 591, the vertical transfer gate 540, the color filter 2140, the micro-lens 2130, and the DTI area 560. Details about the semiconductor substrate 510, the vertical transfer gate 540, the color filter 2140, and the micro-lens 2130 correspond to those about respective components described with reference to FIG. 5A, and thus, redundant description will be omitted.

Referring to FIG. 6C, the second area 520e is formed within a range surrounding the first areas 520c and 520d, and the contact area 591 is formed in the second area 520e, and thus, holes generated in the second area 520e may be transferred to a sensing circuit. According to some example embodiments, the first areas 520c and 520d may share the second area 520e.

According to the inventive concepts, in a hybrid pixel sharing 4PD, one second area 520e may be formed to surround four first areas 520a, 520b, 520c, and 520d, and thus, the second area 520e may be shared. According to some example embodiments, it should be noted that, in the hybrid pixel sharing 4PD, the four first areas 520a, 520b, 520c, and 520d are considered as one pixel, and thus, the DTI area 560 may be formed for distinguishment from an adjacent hybrid pixel.

In comparison with FIG. 5A, when the first area 2120a and the second area 2120b, which are included in the photoelectric conversion area 2120, are in a 1:1 correspondence in FIG. 5A, the DTI areas 2150 and 2160 may be formed such that the photoelectric conversion area 2120 is isolated from an adjacent photoelectric conversion area. In FIG. 6C, when the first areas 520a, 520b, 520c, and 520d and the second area 520e, which are included in the photoelectric conversion areas 520, are not in a 1:1 correspondence, the plurality of first areas 520a, 520b, 520c, and 520d may share the second area 520e. In this case, the DTI area 560 may be formed such that the second area 520e is isolated from an adjacent second area. In other words, it should be noted that a DTI area may be formed such that a second area of a photoelectric conversion area in a same conductivity type as a substrate is completely (e.g., fully) isolated from a second area of an adjacent photoelectric conversion area.

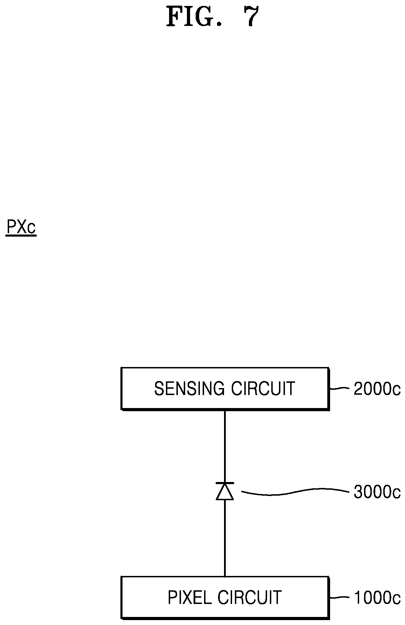

FIG. 7 is a circuit diagram of a hybrid pixel PXc according to some example embodiments.

Referring to FIG. 7, the hybrid pixel PXc may include a photodiode 3000c, a pixel circuit 1000c connected to one end of the photodiode 3000c, and a sensing circuit 2000c connected to another end of the photodiode 3000c. According to some example embodiments, an anode of the photodiode 3000c may be connected to the pixel circuit 1000c and a cathode of the photodiode 3000c may be connected to the sensing circuit 2000c.

The pixel circuit 1000c may generate a pixel signal of a voltage according to an amount of charged generated in the photodiode 3000c. The sensing circuit 2000c may generate an event detection signal by detecting whether an amount of change in charges generated in the photodiode 3000c has exceeded a certain threshold value. The pixel circuit 1000c included in the hybrid pixel PXc according to the inventive concepts may generate the pixel signal based on holes generated in the photodiode 3000c, and the sensing circuit 2000c may generate the event detection signal based on electrons generated in the photodiode 3000c. Accordingly, the pixel circuit 1000c may use a current based on holes and the sensing circuit 2000c may use a current based on electrons. In this case as well, the pixel circuit 1000c may operate as a circuit separate from the sensing circuit 2000c.

It should be noted that, the inventive concepts as applied to some example embodiments of a pixel circuit using electrons and a sensing circuit using holes may also be applied to a pixel circuit using holes and a sensing circuit using electrons, as in FIG. 7.

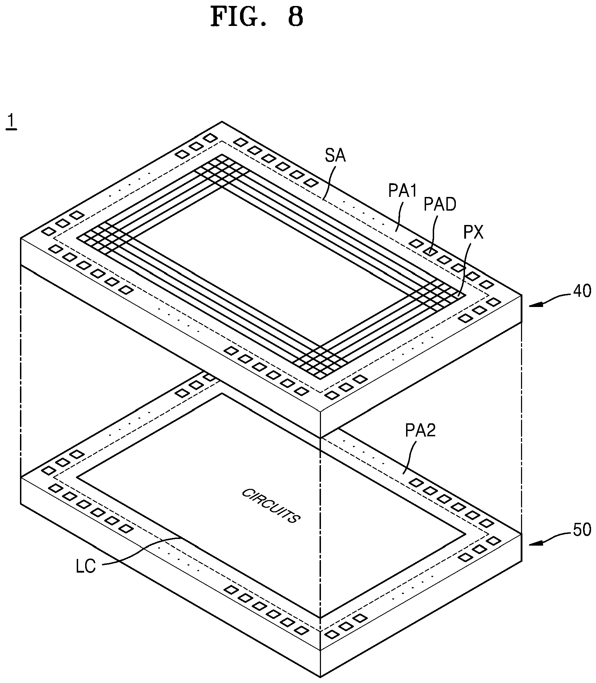

FIG. 8 illustrates a stack structure of a hybrid sensor 1, according to some example embodiments.

Referring to FIG. 8, the hybrid sensor 1 may include an upper chip 40 and a lower chip 50. The upper chip 40 may include a sensing area SA where some circuits of the plurality of pixels PX are provided, and pad area PA1 around the sensing area SA. A plurality of upper pads PAD are arranged in the pad area PA1 and the plurality of upper pads PAD may be connected to elements provided in the lower chip 50 through a via and/or the like.

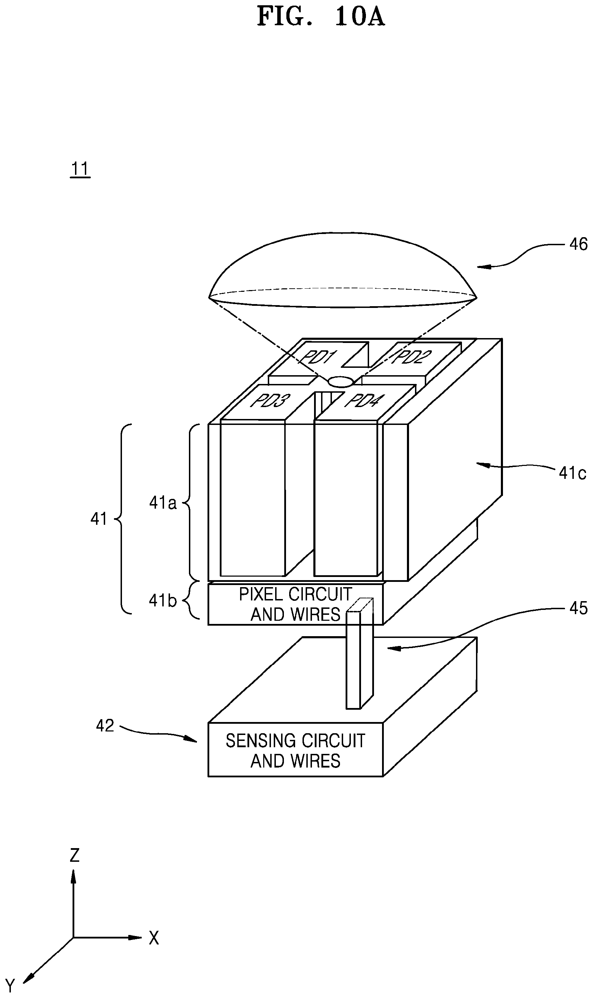

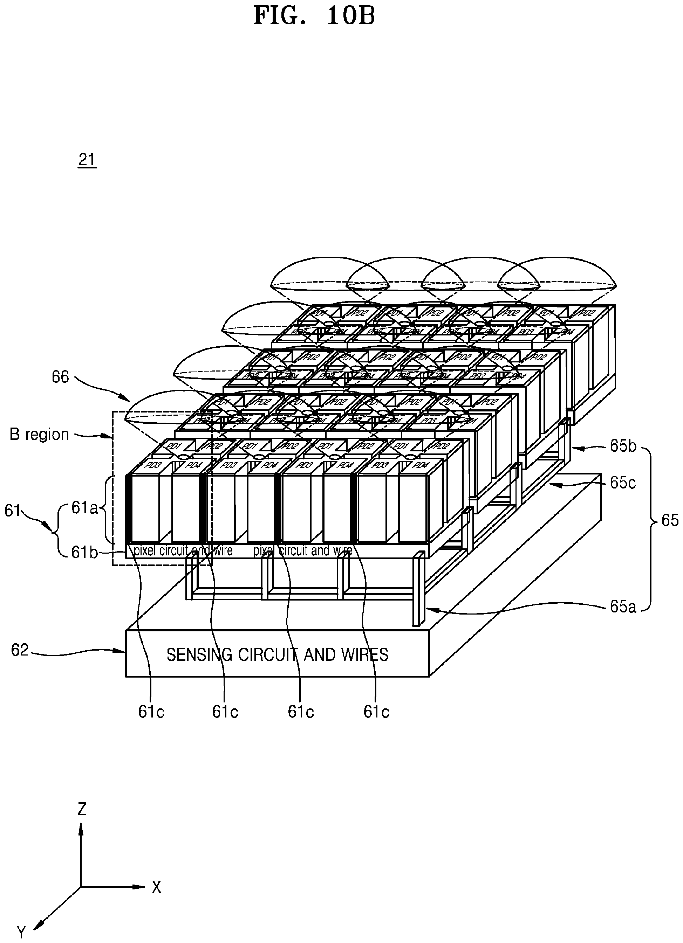

The lower chip 50 includes the circuit area LC, and peripheral circuits of a pixel array, e.g., the row driver 120, the readout circuit 130, the ramp signal generator 140, the timing controller 150, and the event detection circuit 160, may be formed in the circuit area LC. The lower chip 50 includes a pad area PA2 around the circuit area LC. According to some example embodiments, a sensing circuit included in the plurality of pixels PX may be formed in the circuit area LC. This will be described below with reference to FIGS. 10A and 10B. According to some example embodiments, the lower chip 50 may include a memory area and a dummy area. Memory elements, such as dynamic random access memory (DRAM) elements or static random access memory (SRAM) elements, may be arranged in the memory area. However, memory elements arranged in the memory area are not limited to DRAM elements or SRAM elements. The dummy area may perform a function, for example, of supporting the upper chip 40, heat dissipation, etc., instead of a function of storing data.

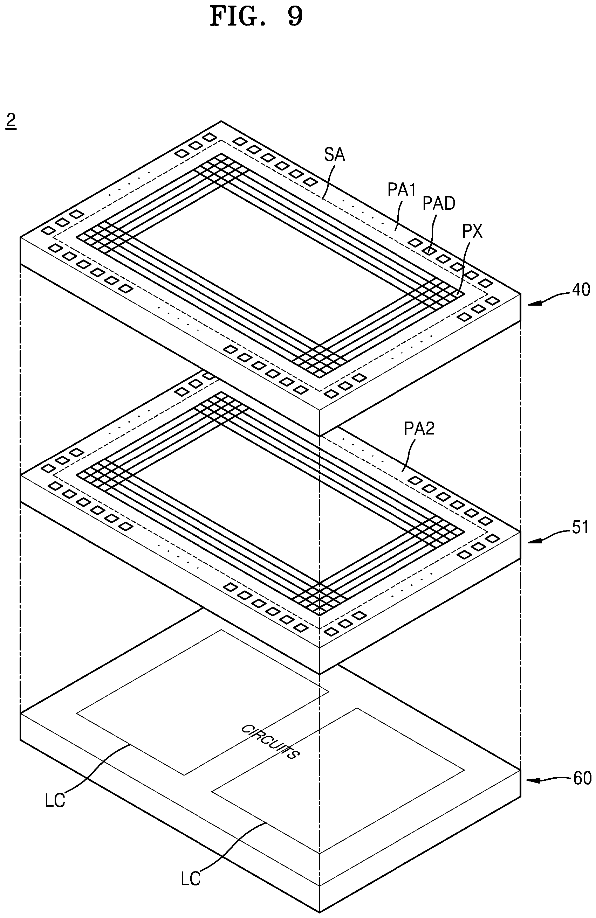

FIG. 9 illustrates a stack structure of a hybrid sensor, according to some example embodiments.

Referring to FIG. 9, the hybrid sensor 2 may include a plurality of stacked chips. For example, a pixel array may be formed in the upper chip 40 and an intermediate chip 51, and peripheral circuits of the pixel array or a memory may be formed in a lower chip 60. According to some example embodiments, a plurality of photodiodes, a pixel circuit, and wires corresponding thereto, which are included in a hybrid pixel, may be formed in the upper chip 40, and a sensing circuit and wires corresponding thereto may be formed in the intermediate chip 51.

The lower chip 60 may include the circuit area LC and the peripheral circuits of the pixel array may be formed in the circuit area LC. According to some example embodiments, the lower chip 60 may include a memory area and a dummy area.

According to some example embodiments, the upper chip 40 and the intermediate chip 51 may be stacked on each other in a wafer level, and the lower chip 60 may be attached below the intermediate chip 51 in a chip level.

FIG. 10A illustrates a stack structure of components of a hybrid pixel included in a hybrid sensor, according to some example embodiments.

For convenience of description, some example embodiments in which a wiring structure of the first to fourth photodiodes PD1, PD2, PD3, and PD4, a pixel circuit, and a sensing circuit, which are included in one hybrid pixel 11, is applied to a stack structure is illustrated.

Referring to FIG. 10A, the hybrid pixel 11 may include an upper chip 41 and a lower chip 42. The upper chip 41 may include a first area 41a where the first to fourth photodiodes PD1, PD2, PD3, and PD4 are formed, and a second area 41b where a pixel circuit and wires corresponding thereto are formed, below the first area 41a. A sensing circuit and wires corresponding thereto may be formed in the lower chip 42. An object lens 46 for applying light to the first to fourth photodiodes PD1, PD2, PD3, and PD4 included in the upper chip 41 may be arranged on an upper area of the upper chip 41.

According to some example embodiments, the upper chip 41 of the hybrid pixel 11 may correspond to the upper chip 40 of FIG. 8, and the lower chip 42 of the hybrid pixel 11 may correspond to the lower chip 50 of FIG. 8. According to some example embodiments, the upper chip 41 of the hybrid pixel 11 may correspond to the upper chip 40 of FIG. 9, and the lower chip 42 of the hybrid pixel 11 may correspond to the intermediate chip 51 of FIG. 9.

According to some example embodiments, the pixel circuit uses electrons and thus may include an n-channel metal oxide semiconductor (NMOS) transistor, and the sensing circuit may include both an NMOS transistor and a p-channel metal oxide semiconductor (PMOS) transistor. Thus, an efficient stack structure may be formed by forming the sensing circuit including both the NMOS transistor and the PMOS transistor on a layer separate from the pixel circuit and a photodiode. In one example, a first layer may include the pixel circuit and at least one photodiode, and a second, different layer may include the sensing circuit.

According to some example embodiments, the plurality of first to fourth photodiodes PD1, PD2, PD3, and PD4 may be shared with each other and correspond to one hybrid pixel. According to some example embodiments, the hybrid pixel 11 including the plurality of first to fourth photodiodes PD1, PD2, PD3, and PD4 may be isolated from an adjacent hybrid pixel through a DTI area 41c. According to some example embodiments, the DTI area 41c may be formed according to a depth of the first area 41a where the plurality of first to fourth photodiodes PD1, PD2, PD3, and PD4 are formed. Referring to FIG. 10A, the DTI area 41c is formed only on a right side of the first area 41a where the first to fourth photodiodes PD1, PD2, PD3, and PD4 are formed, but this is for convenience of description, and it should be noted that the DTI area 41c is formed to surround all four sides of the first area 41a where the first to fourth photodiodes PD1, PD2, PD3, and PD4 are formed. According to the inventive concepts, by using the DTI area 41c that is physically separated from an adjacent hybrid pixel, individual sensing pixels respectively corresponding to sensing circuits may be formed.

Although not illustrated in FIG. 10A, the plurality of first to fourth photodiodes PD1, PD2, PD3, and PD4 may include a first area and a second area, and may share the second area. Details thereof correspond to those described with reference to FIGS. 6A to 6C, and thus, redundant description will be omitted.

According to some example embodiments, the upper chip 41 and the lower chip 42 may be electrically connected to each other through a vertical area 45. The vertical area 45 extends in a Z-axis direction and may be in contact with each of the upper chip 41 and the lower chip 42. According to some example embodiments, the vertical area 45 may be a via for connecting charges generated in the first to fourth photodiodes PD1, PD2, PD3, and PD4 to the sensing circuit. According to some example embodiments, the vertical area 45 may be a through silicon via (TSV) or a chip-to-chip (C2C) for connecting the charges of the first to fourth photodiodes PD1, PD2, PD3, and PD4 to the sensing circuit.

FIG. 10B illustrates a stack structure of components of a hybrid pixel 21 included in a hybrid sensor, according to some example embodiments.

For convenience of description, some example embodiments in which a wiring structure of photodiodes, a pixel circuit, and a sensing circuit, which are included in a plurality of hybrid pixels, is applied to a stack structure is illustrated. According to some example embodiments, an upper chip 61 of the hybrid pixel 21 may correspond to the upper chip 40 of FIG. 8, and a lower chip 62 of the hybrid pixel 21 may correspond to the lower chip 50 of FIG. 8. According to some example embodiments, the upper chip 61 of the hybrid pixel 21 may correspond to the upper chip 40 of FIG. 9, and the lower chip 62 of the hybrid pixel 21 may correspond to the intermediate chip 51 of FIG. 9.

Referring to FIG. 10B, the hybrid pixel 21 may include the upper chip 61 and the lower chip 62. The upper chip 61 may include a first area 61a where the first to fourth photodiodes PD1, PD2, PD3, and PD4 are formed, and a second area 61b where a pixel circuit and wires corresponding thereto are formed, below the first area 61a. A sensing circuit and wires corresponding thereto may be formed in the lower chip 62. Object lenses 66 for applying light to the first to fourth photodiodes PD1, PD2, PD3, and PD4 included in the upper chip 61 may be arranged on an upper area of the upper chip 61.

FIG. 10B illustrates a stack structure in which sixteen hybrid pixels 11 of FIG. 10A are arranged. A B region of FIG. 10B corresponds to the first area 41a and the second area 41b formed in the upper chip 41 of FIG. 10A, and thus, redundant description thereof is omitted.

Referring to FIG. 10B, a plurality of hybrid pixels may be physically separated by DTI areas 61c. In some example embodiments of FIGS. 10A and 10B, a hybrid pixel may denote a pixel corresponding to one unit sharing the plurality of first to fourth photodiodes PD1, PD2, PD3, and PD4. According to some example embodiments, the DTI area 61c may be formed according to a depth of the first area 61a where the plurality of first to fourth photodiodes PD1, PD2, PD3, and PD4 are formed. Referring to FIG. 10B, some example embodiments in which the DTI areas 61c are formed only between four hybrid pixels in front of the first area 61a where the first to fourth photodiodes PD1, PD2, PD3, and PD4 are formed is illustrated, but this is only for convenience of description, and it should be noted that the DTI area 61c is formed to surround each of hybrid pixels sharing the first to fourth photodiodes PD1, PD2, PD3, and PD4, in order to prevent or reduce crosstalk with an adjacent hybrid pixel.

Although not illustrated in FIG. 10B, the plurality of first to fourth photodiodes PD1, PD2, PD3, and PD4 may include a first area and a second area, and may share the second area. Details thereof correspond to those described with reference to FIGS. 6A to 6C, and thus, redundant description will be omitted.

Referring to FIG. 10B, the upper chip 61 and the lower chip 62 may be electrically connected to each other through a vertical area 65. The vertical area 65 extends in a Z-axis direction and may be in contact with each of the upper chip 61 and the lower chip 62. According to some example embodiments, the vertical area 65 may be a via for connecting charges of the first to fourth photodiodes PD1, PD2, PD3, and PD4 to a sensing circuit. According to some example embodiments, the vertical area 65 may be a TSV or C2C for connecting charges of the first to fourth photodiodes PD1, PD2, PD3, and PD4 to the sensing circuit.

Referring to FIG. 10B, the vertical areas 65 for connecting holes of a plurality of hybrid pixels to one sensing circuit may be provided instead of providing one vertical area 45 for connecting a pixel circuit and a sensing circuit, included in one hybrid pixel, as shown in FIG. 10A.

Referring to FIG. 10B, to connect outputs of photodiodes included in each of a plurality of hybrid pixels to one, a plurality of first vertical areas 65b perpendicularly connected to an output of each hybrid pixel (for example, electrically connected), a plurality of first planar areas 65c connecting the plurality of first vertical areas 65b on an X-Y plane (for example, electrically connected), and at least one second vertical area 65a connecting the plurality of first vertical areas 65b and the plurality of first planar areas 65c to the sensing circuit (for example, electrically connected) may be provided. According to some example embodiments, each of the plurality of first vertical areas 65b may be vertical areas for connecting charges respectively corresponding to contact areas included in hybrid pixels, that is, each of the plurality of first vertical areas 65b may be electrically connected to corresponding contact areas included in the hybrid pixels.

Referring to FIG. 10B, only one second vertical area 65a is illustrated, but this is only an example, and it should be noted that a plurality of second vertical areas 65a may be provided. Referring to FIG. 10B, the contact areas separated by DTI areas in the upper chip 61 may be connected to one sensing circuit by being combined into one wire through wires such as metal or polysilicon included in the vertical areas 65.

Referring to some example embodiments of FIG. 10B, when the sensing circuit performs event detection by mixing outputs of sixteen hybrid pixels, it is possible to connect 16 times greater signals, and accordingly, operation in low illumination may be facilitated. According to some example embodiments, outputs of hole signals of a plurality of hybrid pixels may be connected as shown in FIG. 10B to secure the area and sensitivity of a sensing circuit. According to some example embodiments, when color information is not required in a sensing circuit, a wire may be formed by connecting hole signals of photodiodes corresponding to RGB.

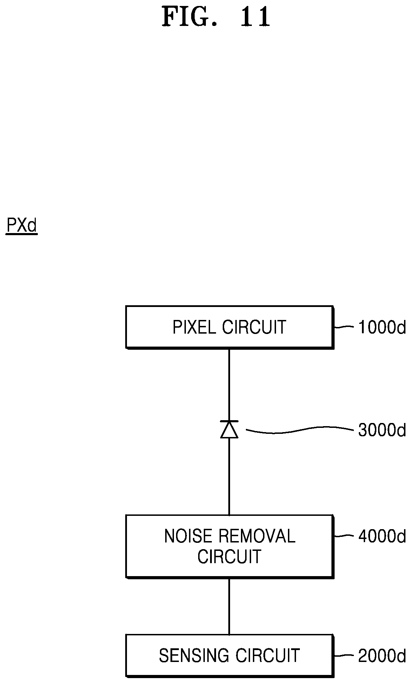

FIG. 11 is a block diagram of a structure of a hybrid pixel PXd, according to some example embodiments.

Referring to FIG. 11, the hybrid pixel PXd may include a photodiode 3000d, a pixel circuit 1000d, a sensing circuit 2000d, and a noise removal circuit 4000d. While describing FIG. 11, details that overlap those described in FIG. 4A will be omitted. According to some example embodiments, in the sensing circuit 2000d using holes, noise caused by a TIA may occur and when the noise shakes a ground level, signal-to-noise ratio (SNR) of a pixel signal may be affected. Referring to FIG. 11, the noise removal circuit 4000d may be connected between the photodiode 3000d and the sensing circuit 2000d. The noise removal circuit 4000d may be connected between an anode of the photodiode 3000d and the sensing circuit 2000d. The noise removal circuit 4000d may include a plurality of transistors and noise occurred by the sensing circuit 2000d may be removed by adjusting on-off of the plurality of transistors.

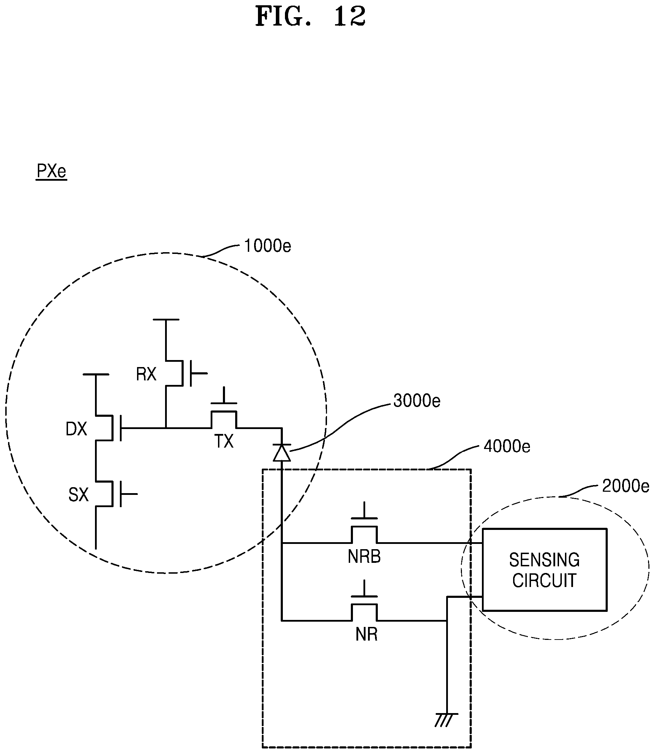

FIG. 12 is a circuit diagram of a hybrid pixel PXe, according to some example embodiments.

Referring to FIG. 12, the hybrid pixel PXe may include a pixel circuit 1000e, a sensing circuit 2000e, a photodiode 3000e, and a noise removal circuit 4000e. The pixel circuit 1000e may include the transfer transistor TX, the reset transistor RX, the driving transistor DX, and the selection transistor SX. A structure of the sensing circuit 2000e may correspond to a structure of the sensing circuit 2000 shown in FIG. 4A. According to some example embodiments, details about the pixel circuit 1000e, the sensing circuit 2000e, and the photodiode 3000e correspond to details about a pixel circuit, a sensing circuit, and a photodiode described with reference to FIGS. 4A to 10B, and thus, redundant description will be omitted.

The noise removal circuit 4000e may include a first transistor NRB and a second transistor NR. According to some example embodiments, the first transistor NRB may be connected between an anode of the photodiode 3000e and the sensing circuit 2000e. The second transistor NR may be connected between the anode of the photodiode 3000e and a ground. According to some example embodiments, the first transistor NRB and the second transistor NR may be connected to each other in parallel. The noise removal circuit 4000e may configure a circuit connecting or releasing the sensing circuit 2000e by using the first transistor NRB and the second transistor NR. According to some example embodiments, the first transistor NRB of the noise removal circuit 4000e may be a transistor configured to control a connection between a contact area of the photodiode 3000e and the sensing circuit 2000e, and the second transistor NR may be a transistor configured to control a connection between the contact area of the photodiode 3000e and the ground or between different specific voltages.

When the first transistor NRB is turned on and the second transistor NR is turned off, the photodiode 3000e and the sensing circuit 2000e may be connected to each other. In this case, holes generated in the photodiode 3000e may be transferred to the sensing circuit 2000e. When the first transistor NRB is turned off and the second transistor NR is turned on, the photodiode 3000e and the ground may be connected to each other and the holes generated in the photodiode 3000e may flow to the ground, and thus, a hole current may be drained. As such, by controlling on and off of the first transistor NRB and the second transistor NR, a connection between the sensing circuit 2000e and the photodiode 3000e may be adjusted.

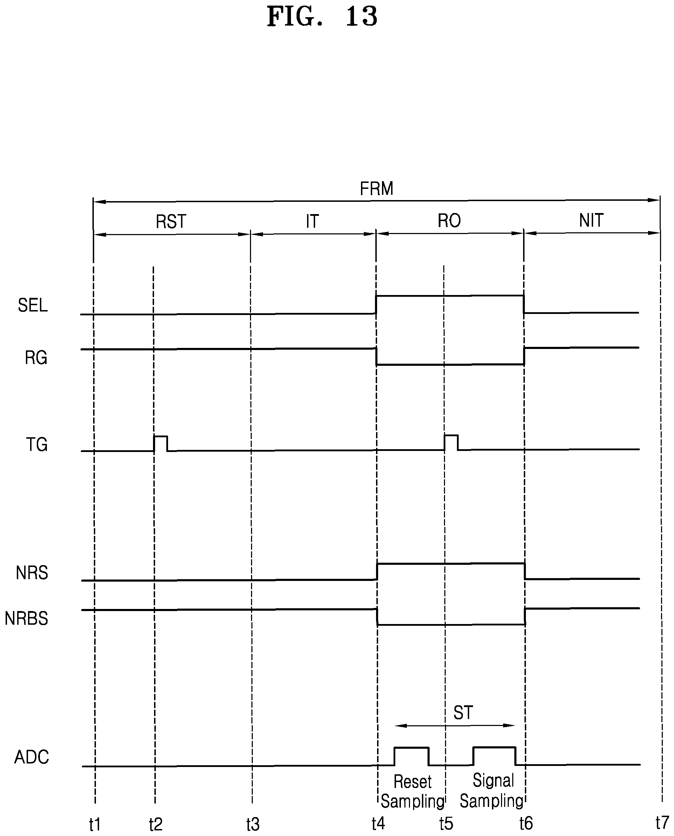

FIG. 13 is a timing diagram for describing turn-on timing of transistors included in the noise removal circuit 4000e of FIG. 12.

FIG. 13 illustrates a timing diagram of a selection control signal SEL applied to the selection transistor SX, a reset control signal RG applied to the reset transistor RX, a transfer control signal TG applied to the transfer transistor TX, a first control signal NRBS applied to the first transistor NRB, and a second control signal NRS applied to the second transistor NR. In one example, the timing diagram may further refer to the ADC.

Referring to FIG. 13, sections corresponding to one frame are illustrated. During one frame FRM, a reset time RST, an exposure time IT, a read time RO, and a non-integration time NIT may be assigned for each of a plurality of rows. The reset time RST corresponding to sections of t1 to t3, the exposure time IT corresponding to sections of t3 and t4, the read time RO corresponding to sections of t4 to t6, and the non-integration time NIT corresponding to sections of t6 and t7 are illustrated.

During the reset time RST corresponding to the sections of t1 to t3, a pixel may be reset. At a time point t2, the transfer transistor TX included in the pixel may be turned on and transmit charges generated in a photodiode during the non-integration time NIT to a floating diffusion node, thereby removing the charges. During the reset time RST, the reset control signal RG applied to the reset transistor RX maintains a second level, and thus, the transfer transistor TX of the pixel is turned on while a reset voltage is applied to the floating diffusion node. Accordingly, the floating diffusion node and the pixel may be reset together.

During the exposure time IT corresponding to the sections t3 and t4, charges corresponding to an optical signal may be generated and accumulated in a photodiode included in the pixel. The pixel may be read during the read time RO corresponding to the sections t4 to t6. At a time point t5, the transfer transistor TX included in the pixel is turned on and the charges accumulated in the photodiode are transmitted to the floating diffusion node during the exposure time IT, and a pixel voltage corresponding to the transmitted charges may be output through the column line CL of FIG. 1. During the read time RO before the time point t5, sampling (reset sampling) of a signal corresponding to the reset voltage may be performed, and during the read time RO after the time point t5, sampling (signal sampling) of a signal corresponding to an image voltage may be performed. At a time point t4 that is a start time point of the read time RO, the selection control signal SEL applied to the selection transistor SX may be changed from a first level to the second level, and the reset control signal RG applied to the reset transistor RX may be changed from the second level to the first level. At a time point t6 that is an end time point of the read time RO, the selection control signal SEL applied to the selection transistor SX may be changed from the second level to the first level, and the reset control signal RG applied to the reset transistor RX may be changed from the first level to the second level. In the inventive concepts, the first level may be a low level and the second level may be a high level.

According to some example embodiments, during the reset time RST, the exposure time IT, and the non-integration time NIT, the second control signal NRS applied to the second transistor NR may maintain the first level, and during the read time RO, the second control signal NRS applied to the second transistor NR may maintain the second level. According to some example embodiments, during the reset time RST, the exposure time IT, and the non-integration time NIT, the first control signal NRBS applied to the first transistor NRB may maintain the second level, and during the read time RO, the first control signal NRBS applied to the first transistor NRB may maintain the first level. According to some example embodiments, at the time point t4 that is the start time point of the read time RO, the second control signal NRS may be changed from the first level to the second level, and the first control signal NRBS may be changed from the second level to the first level. According to some example embodiments, at the time point t6 that is the end time point of the read time RO, the second control signal NRS may be changed from the second level to the first level, and the first control signal NRBS may be changed from the first level to the second level. According to some example embodiments, the first transistor NRB and the second transistor NR may be complementary. The second transistor NR may be turned off when the first transistor NRB is turned on, and the second transistor NR may be turned on when the first transistor NRB is turned off.

According to some example embodiments, the first control signal NRBS applied to the first transistor NRB may be changed from the second level to the first level before a CDS sampling time ST, and may be changed from the first level to the second level after the CDS sampling time ST. According to some example embodiments, the second control signal NRS applied to the second transistor NR may be changed from the first level to the second level before the CDS sampling time ST, and may be changed from the second level to the first level after the CDS sampling time ST. The CDS sampling time ST may be a section included in the read time RO.

In other words, the first transistor NRB is turned off and the second transistor NR is turned on during the read time RO so as to block a path that may be connected to the sensing circuit 2000e during the read time RO and block noise that may occur by the sensing circuit 2000e during the read time RO. According to some example embodiments, the read time RO may be most vulnerable to noise, and thus, noise may be removed by controlling signals applied to the transistors included in the noise removal circuit 4000e according to the inventive concepts.

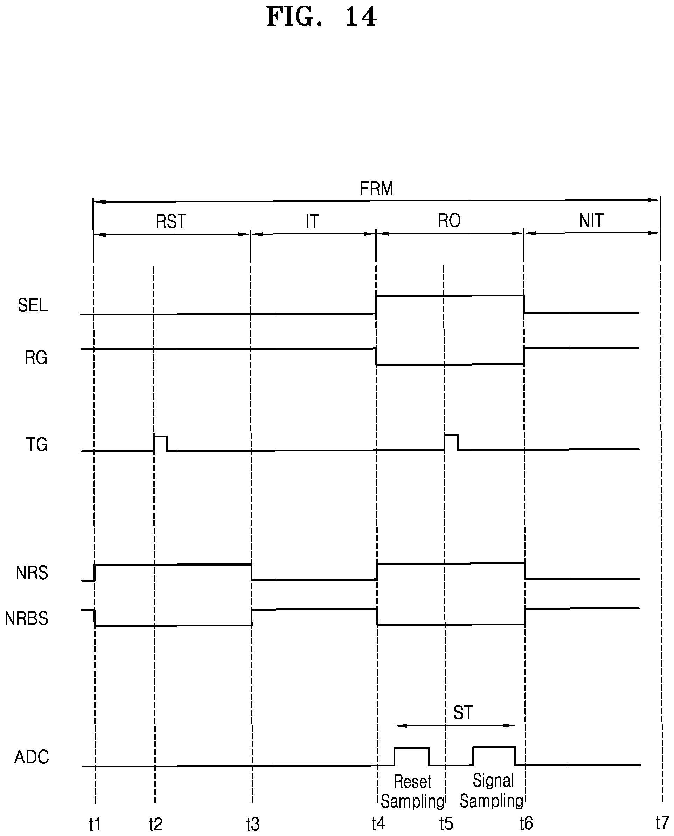

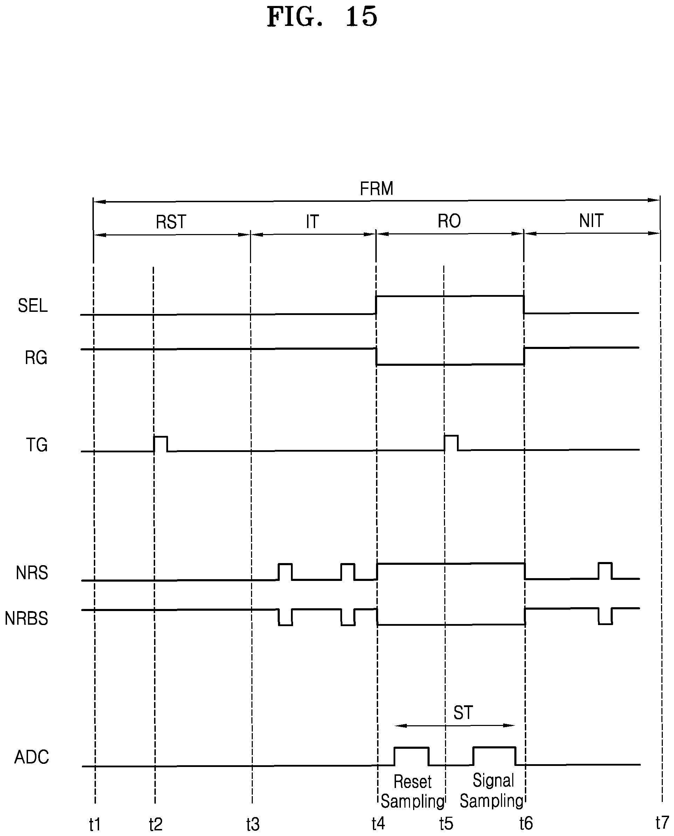

FIGS. 14 and 15 are timing diagrams for describing turn-on timing of transistors included in a noise removal circuit according to some example embodiments. While describing FIGS. 14 and 15, details that overlap those described with reference to FIG. 13 will be omitted.

Referring to FIG. 14, during the reset time RST corresponding to the sections of t1 to t3, the second control signal NRS applied to the second transistor NR may maintain the second level and the first control signal NRBS applied to the first transistor NRB may maintain the first level. According to some example embodiments, at a time point t1 that is a start time point of the reset time RST, the second control signal NRS may be changed from the first level to the second level, and the first control signal NRBS may be changed from the second level to the first level. According to some example embodiments, at a time point t3 that is an end time point of the reset time RST, the second control signal NRS may be changed from the second level to the first level, and the first control signal NRBS may be changed from the first level to the second level.

Referring to some example embodiments of FIG. 14, by controlling the second transistor NR to be turned on and the first transistor NRB to be turned off during the reset time RST corresponding to the sections of t1 to t3, noise that may occur in the sensing circuit 2000e may have little to no influence even during a reset operation.

In FIGS. 13 and 14, some example embodiments in which the second transistor NR is turned on and the first transistor NRB is turned off during the entire section of the reset time RST and/or the read time RO is illustrated, but the inventive concepts are not limited thereto, and the second transistor NR may be turned on and the first transistor NRB may be turned off during a time corresponding to 90% or more of the entire section of the reset time RST and/or the read time RO. According to some example embodiments, the second transistor NR may be turned off and the first transistor NRB may be turned on in a partial section of the reset time RST and/or the read time RO. According to some example embodiments, during the reset time RST, the second control signal NRS may be changed from the first level to the second level so that the first control signal NRBS is changed from the second level to the first level before a time point (the time point t2) when the transfer control signal TG applied to the transfer transistor TX is changed from the first level to the second level, and the second control signal NRS may be changed from the second level to the first level so that the first control signal NRBS is changed from the first level to the second level after the time point when the transfer control signal TG applied to the transfer transistor TX is changed from the second level to the first level.

Referring to some example embodiments of FIG. 15, the first control signal NRBS may maintain the first level during partial sections of the exposure time IT and non-integration time NIT, and the second control signal NRS may maintain the second level during partial sections of the exposure time IT and non-integration time NIT. According to some example embodiments, during the exposure time IT and non-integration time NIT corresponding to sections previous to and following the read time RO of the photodiode, the second transistor NR may be turned on during a partial section and the first transistor NRB may be turned off. Accordingly, noise that may occur during a section aside from the reset time RST and read time RO may be removed or reduced intermittently.

In the description of the timing diagrams of FIGS. 13 to 15, a plurality of control signals SEL, RG, TG, NRS, and NRBS described in the timing diagrams may be generated by the row driver 120 of FIG. 2, and timing control of the plurality of control signals SEL, RG, TG, NRS, and NRBS described in the timing diagrams may be controlled by the timing controller 150 of FIG. 2.

Any or all of the elements described with reference to the figures may communicate with any or all other elements described with reference to figures. For example, any element may engage in one-way and/or two-way and/or broadcast communication with any or all other elements in the figures, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

In one example, the inventive concept may provide a hybrid pixel without a light loss or any issue with an operation of a pixel, realized by using an electron current as an active pixel sensor (APS) and a hole current that is drained through the ground as a dynamic vision sensor (DVS). Front deep trench isolation (FDTI) may be used to separate hole currents between adjacent pixels. In one example, a noise removal circuit for removing noise occurring from a hole current may be used to resolve a noise-related issue that may be generated in the hybrid pixel.
Embodiments are set out in the following clauses:
Clause 1. A hybrid pixel comprising: a semiconductor substrate; a pixel circuit including at least one transfer transistor; a sensing circuit configured to detect movement of an object; and at least one photodiode having one end connected to the pixel circuit and another end connected to the sensing circuit, the semiconductor substrate having a first conductivity type, the semiconductor substrate including a photoelectric conversion area corresponding to the at least one photodiode, the semiconductor substrate including a first area of a second conductivity type and a second area surrounding the first area, the second area physically separated from a second area of an adjacent hybrid pixel by a deep trench isolation area, and the semiconductor substrate including the deep trench isolation area.
Clause 2. The hybrid pixel of clause 1, wherein the first conductivity type is a p type and the second conductivity type is an n type.
Clause 3. The hybrid pixel of clause 1 or 2, wherein the deep trench isolation area is a front deep trench isolation.
Clause 4. The hybrid pixel of any preceding clause, wherein a number of the at least one photodiode and a number of the at least one transfer transistor are a same number.
Clause 5. The hybrid pixel of clause 4, wherein a number of the first areas corresponds to the number of the at least one photodiode and a number of the second areas is less than or equal to the number of the first areas.
Clause 6. The hybrid pixel of any preceding clause, wherein the pixel circuit is connected to a cathode of the at least one photodiode and the sensing circuit is connected to an anode of the at least one photodiode.
Clause 7. The hybrid pixel of any one of clauses 1 to 6, wherein the pixel circuit is connected to an anode of the at least one photodiode and the sensing circuit is connected to a cathode of the at least one photodiode.
Clause 8. A hybrid pixel comprising: a semiconductor substrate; a pixel circuit including at least one transfer transistor; a sensing circuit configured to detect movement of an object; and at least one photodiode having one end connected to the pixel circuit and another end connected to the sensing circuit, the semiconductor substrate having a first conductivity type, the semiconductor substrate including a photoelectric conversion area corresponding to the at least one photodiode, the semiconductor substrate including a first area of a second conductivity type and a second area surrounding the first area, the second area physically separated from a second area of an adjacent hybrid pixel by a deep trench isolation area, and a first layer including the pixel circuit and the at least one photodiode is different from a second layer including the sensing circuit.
Clause 9. The hybrid pixel of clause 8, wherein the first layer is above the second layer, and the hybrid pixel further comprises a vertical area to electrically connect the first layer and the second layer to each other.
Clause 10. The hybrid pixel of clause 9, wherein the vertical area is a through silicon via or a chip-to-chip.
Clause 11. The hybrid pixel of clause 9 or 10, wherein the vertical area comprises: a plurality of first vertical areas electrically connected to each other, corresponding to a plurality of second areas in the first layer; planar areas connecting the plurality of first vertical areas on a plane; and a second vertical area connecting the plurality of first vertical areas and the planar areas to the sensing circuit.
Clause 12. The hybrid pixel of any one of clauses 9 to 11, wherein the deep trench isolation area is a front deep trench isolation.
Clause 13. A hybrid sensor comprising: a pixel array including a plurality of hybrid pixels, the plurality of hybrid pixels comprising a photodiode; a pixel circuit connected to one end of the photodiode; a sensing circuit connected to another end of the photodiode; and a noise removal circuit connected between the sensing circuit and the other end of the photodiode, and each of the plurality of hybrid pixels is physically separated from an adjacent hybrid pixel by a deep trench isolation area.
Clause 14. The hybrid sensor of clause 13, wherein the noise removal circuit comprises: a first transistor connected between the other end of the photodiode and the sensing circuit; and a second transistor connected between the other end of the photodiode and a ground.
Clause 15. The hybrid sensor of clause 14, further comprising: a row driver configured to generate signals applied to the pixel array; and a timing controller configured to control timings of the signals generated by the row driver, wherein the timing controller is configured to control timings of a first control signal and a second control signal, which are applied respectively to the first transistor and the second transistor.

Hereinabove, some example embodiments have been described in the drawings and specification. In the present specification, although the example embodiments have been described by using specific terms, the terms are used only for descriptive purposes and are not intended to limit the meanings or scope of the inventive concepts described in the claims. Therefore, it will be understood by one of ordinary skill in the art that other modifications and equivalents may be made therein. Accordingly, the scope of the inventive concepts will be defined by the appended claims.

## Claims

1. A hybrid pixel comprising:
a semiconductor substrate;
a pixel circuit including at least one transfer transistor;
a sensing circuit configured to detect movement of an object; and
at least one photodiode having one end connected to the pixel circuit and another end connected to the sensing circuit,
the semiconductor substrate having a first conductivity type, the semiconductor substrate including a photoelectric conversion area corresponding to the at least one photodiode, the semiconductor substrate including a first area of a second conductivity type and a second area surrounding the first area,
the second area physically separated from a second area of an adjacent hybrid pixel by a deep trench isolation area, and
the semiconductor substrate including the deep trench isolation area.

2. The hybrid pixel of claim **1,** wherein the first conductivity type is a p type and the second conductivity type is an n type.

3. The hybrid pixel of claim 1 or 2, wherein the deep trench isolation area is a front deep trench isolation.

4. The hybrid pixel of any preceding claim, wherein a number of the at least one photodiode and a number of the at least one transfer transistor are a same number.

5. The hybrid pixel of claim 4, wherein a number of the first areas corresponds to the number of the at least one photodiode and a number of the second areas is less than or equal to the number of the first areas.

6. The hybrid pixel of any preceding claim, wherein the pixel circuit is connected to a cathode of the at least one photodiode and the sensing circuit is connected to an anode of the at least one photodiode.

7. The hybrid pixel of any one of claims 1 to 6, wherein the pixel circuit is connected to an anode of the at least one photodiode and the sensing circuit is connected to a cathode of the at least one photodiode.

8. The hybrid pixel of any preceding claim, further comprising:
a first layer including the pixel circuit and the at least one photodiode is different from a second layer including the sensing circuit.

9. The hybrid pixel of claim 8, wherein
the first layer is above the second layer, and
the hybrid pixel further comprises a vertical area to electrically connect the first layer and the second layer to each other.

10. The hybrid pixel of claim 9, wherein the vertical area is a through silicon via or a chip-to-chip.

11. The hybrid pixel of claim 9 or 10, wherein the vertical area comprises:
a plurality of first vertical areas electrically connected to each other, corresponding to a plurality of second areas in the first layer;
planar areas connecting the plurality of first vertical areas on a plane; and
a second vertical area connecting the plurality of first vertical areas and the planar areas to the sensing circuit.

12. The hybrid pixel of any one of claims 9 to 11, wherein the deep trench isolation area is a front deep trench isolation.

13. A hybrid sensor comprising:
a pixel array including a plurality of hybrid pixels,
the plurality of hybrid pixels comprising
a photodiode;
a pixel circuit connected to one end of the photodiode;
a sensing circuit connected to another end of the photodiode; and
a noise removal circuit connected between the sensing circuit and the other end of the photodiode, and
each of the plurality of hybrid pixels is physically separated from an adjacent hybrid pixel by a deep trench isolation area.

14. The hybrid sensor of claim 13, wherein the noise removal circuit comprises:
a first transistor connected between the other end of the photodiode and the sensing circuit; and
a second transistor connected between the other end of the photodiode and a ground.

15. The hybrid sensor of claim 14, further comprising:
a row driver configured to generate signals applied to the pixel array; and
a timing controller configured to control timings of the signals generated by the row driver,
wherein the timing controller is configured to control timings of a first control signal and a second control signal, which are applied respectively to the first transistor and the second transistor.
